(19) Europäisches Patentamt
European Patent Office
Office européen des brevets

(11) **EP 1 810 415 B1**

(12) **FASCICULE DE BREVET EUROPEEN**

(45) Date de publication et mention
de la délivrance du brevet:
**13.05.2009 Bulletin 2009/20**

(51) Int Cl.:
***H04B 1/69*** *(2006.01)*

(21) Numéro de dépôt: **05815260.4**

(86) Numéro de dépôt international:
**PCT/FR2005/002711**

(22) Date de dépôt: **28.10.2005**

(87) Numéro de publication internationale:
**WO 2006/048544 (11.05.2006 Gazette 2006/19)**

(54) **GENERATEUR D'IMPULSIONS ET EMETTEUR RADIOFREQUENCE ULTRA LARGE BANDE**

ULTRABREITBAND-HOCHFREQUENZSENDER UND -IMPULSGENERATOR

ULTRA-WIDE BAND RADIO-FREQUENCY TRANSMITTER AND PULSE GENERATOR

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **29.10.2004 FR 0411619**

(43) Date de publication de la demande:
**25.07.2007 Bulletin 2007/30**

(73) Titulaire: **Groupe des Ecoles de Telecommunications Ecole National Superieure des Telecommunications 75634 Paris Cedex 13 (FR)**

(72) Inventeurs:
• **NAVINER, Jean-François**
**F-93150 le Blanc-Mesnil (FR)**
• **THAI-SINGAMA, Richard**
**F-95140 Garges-les-Gonesse (FR)**

(74) Mandataire: **Hirsch & Associés**
**58, avenue Marceau**
**75008 Paris (FR)**

(56) Documents cités:
**US-A- 5 586 145** **US-A1- 2003 234 696**

• **BUCHEGGER, THOMAD AND OSSBERGER, GERALD: "A novel low-cost ultra wideband microstrip pulse forming network for gaussian monocycle generation" 2003 IWUWBS, [Online] 5 juin 2003 (2003-06-05), XP002333381 OULU Extrait de l'Internet: URL:http://www.cwc.oulu.fi/ home/iwuwbs/sli des/buchegger.pdf> [extrait le 2005-06-24] cité dans la demande**
• **"Electormagnetic compatibility and radio süectrum matters (ERM); short range device (SRD); technical characteristics for SRD equipment using ultra wide band technology (UWB) Part 1: communications applications" ETSI TR 101 994-1 V1.1.1, [Online] vol. 1.1.1, no. 1019941, janvier 2004 (2004-01), XP002333382 Extrait de l'Internet: URL:http: //www.microwavers.org/files/uwb/E TSI_ 101994-1.pdf> [extrait le 2005-06-23] cité dans la demande**
• **BURKHART DIETRICH: "Analog design challenges from ultra wide-band technology" IHP, [Online] 2004, XP002333383 FRANKFURT Extrait de l'Internet: URL:http://mikro.ee.tu-berlin.de/kleinheub ach2004/Kleinheubach_ Dietrich.pdf> [extrait le 2005-06-23]**

**Description**

La présente invention concerne le domaine des générateurs d'impulsions en particulier de type ultra-large bande UWB (de l'anglais « ultra wide band ») ainsi qu'un émetteur radiofréquence comprenant un générateur d'impulsions.

La technologie UWB est basée sur l'émission d'impulsions radiofréquences de très courtes durées, typiquement de l'ordre de quelques dizaines de picosecondes à quelques nanosecondes, et dont la largeur de bande fréquentielle est très large, généralement au moins 500 MHz voire bien davantage.

Les applications de l'UWB sont diverses, notamment la transmission locale de données numériques sans fil à haut ou bas débit, mais aussi les radars et les systèmes d'imagerie médicale ou autres.

Les réglementations aujourd'hui évoluent pour autoriser l'utilisation de la technologie UWB dans le domaine civil. Ainsi, aux USA, la FCC a autorisé cet usage dans son document FCC 02-48 du 14 février 2002. Ce document pose qu'un dispositif UWB est un dispositif dont la largeur de bande fractionnée est supérieure à 0,25 ou occupe au moins 1,5GHz de spectre. Il précise que la largeur de bande fractionnée est égale à :

$$2x(f_H - f_L)/(f_H + f_L)$$

avec $f_H$ la fréquence haute du point d'émission à -10dB et $f_L$ la fréquence basse du point d'émission à -10dB.

Par ailleurs, ce document définit les masques d'émission spectrale à observer selon les applications envisagées. Le tableau n°1 ci-dessous donne un aperçu des masques définis pour les applications envisagées : il indique la puissance limite d'émission moyenne en dBm/MHz pour les bandes de fréquences considérées.

Tableau n°1 :

| Bande de fréquences (MHz) | Imagerie sous 960 MHz | Imagerie, moyenne fréquence | Imagerie, haute fréquence | applications d'intérieur | Dispositifs portables, y compris extérieurs | Radar de véhicule |
|---|---|---|---|---|---|---|
| 960-1610 | -65.3 | -53.3 | -65.3 | -75.3 | -75.3 | -75.3 |
| 1610-1990 | -53.3 | -51.3 | -53.3 | -53.3 | -63.3 | -61.3 |
| 1990-3100 | -51.3 | -41.3 | -51.3 | -51.3 | -61.3 | -61.3 |
| 3100-10600 | -51.3 | -41.3 | -41.3 | -41.3 | -41.3 | -61.3 |
| 10600-22000 | -51.3 | -51.3 | -51.3 | -51.3 | -61.3 | -61.3 |
| 22000-29000 | -51.3 | -51.3 | -51.3 | -51.3 | -61.3 | -41.3 |
| Au-dessus de 29000 | -51.3 | -51.3 | -51.3 | -51.3 | -61.3 | -51.3 |

En particulier, pour les appareils d'intérieur (dit « indoors »), les appareils portatifs (dit « hand held devices ») et les applications d'imagerie haute-fréquence, la largeur de bande autorisée est 3,1 GHz à 10,6 GHz avec une puissance limite d'émission moyenne de -41,3 dBm/MHz.

L'ETSI a aussi émis un rapport technique sous la référence TR 101 994-1 v.1.1.1 (2004-01) dont la première partie concerne les applications de l'UWB pour la communication.

Les avantages de l'UWB sont bien connus, en particulier la possibilité de cohabiter avec les systèmes classiques à bande étroite sans les perturber dans les systèmes de radiocommunications.

Cependant, la mise en oeuvre de l'UWB nécessite côté émetteur un générateur d'impulsions qui soit apte à générer les impulsions ultracourtes requises et qui soient conformes au gabarit fréquentiel imposé.

L'approche théorique traditionnelle propose l'utilisation d'impulsions de type monocycle Gaussien de durée très courte qui procure en conséquence une grande largeur de bande. Cette approche est par exemple décrite dans US-A-5,687,169 et US-A-5,677,927.

En pratique, US-A-5,586,145 décrit un générateur d'impulsions basé sur un transistor à avalanche. Dans l'ouvrage intitulé « Les générateurs d'impulsions », tome III de J.P. Vabre, il est proposé un générateur d'impulsions recourant à un circuit monostable à diode Tunnel. Lors de la conférence « 2003 International Workshop for Ultra Wideband Systems (IWUWBS) » tenue du 3 au 5 juin 2003 à l'Université d'Oulu, Finlande, Thomas Buchegger et Gerald Oßberger ont proposé un générateur d'impulsions basé sur une diode SRD dans « A novel low-cost ultra wideband microstrip pulse forming network for Gaussian monocycle generation ».

Cependant, ce type de générateur d'impulsions n'est pas satisfaisant. D'abord, le spectre fréquentiel est difficilement maîtrisable étant donné qu'il dépend des caractéristiques intrinsèques des composants. De plus, leur rendement énergétique est mauvais et nécessite un amplificateur UWB onéreux. Par ailleurs, après la génération d'une impulsion, le temps de latence de ces générateurs pour revenir à l'équilibre et permettre la génération d'une nouvelle impulsion est important, ce qui limite la fréquence de répétition des impulsions. Enfin, ces technologies ne sont pas intégrables à bas coût, conjointement avec l'électronique de traitement du signal.

Thomas Buchegger et Gerald Oßberger ont aussi proposé dans le document précité un générateur d'impulsions recourant à un générateur d'échelon suivi d'un dérivateur procurant des impulsions qui sont ensuite appliquées dans un réseau de microrubans pour fournir des monocycles Gaussien. Mais le générateur d'échelon et le dérivateur sont des éléments complexes, onéreux et non intégrables.

Le but de la présente invention est de fournir un générateur d'impulsions qui puisse notamment servir à l'émission en UWB et palliant au moins partiellement les inconvénients précités.

Plus particulièrement, l'invention vise à fournir un générateur d'impulsions UWB simple à réaliser, peu onéreux, mais qui soit néanmoins fiable et utilisable notamment pour l'UWB.

A cette fin, la présente invention propose un générateur d'impulsions, comprenant un oscillateur fournissant un signal sinusoïdal à une fréquence donnée et un filtre réjecteur de bande dont la fréquence de réjection correspond à la fréquence du signal sinusoïdal fourni par l'oscillateur, dans lequel ledit signal sinusoïdal est appliqué à l'entrée du filtre réjecteur de bande.

Suivant des modes de réalisation préférés, le générateur d'impulsions comprend une ou plusieurs des caractéristiques suivantes :

- le filtre réjecteur est d'un ordre supérieur ou égal à deux ;
- le filtre réjecteur est du deuxième ordre présentant un coefficient d'amortissement supérieur ou égal à 0,1 et inférieur ou égal à $\sqrt{2}/2$ ;
- il comprend en outre un filtre passe-haut, le signal fourni par le filtre réjecteur étant appliqué en entrée du filtre passe-haut ;
- le filtre passe-haut est du deuxième ordre, auquel cas le filtre réjecteur est préférentiellement du deuxième ordre, le coefficient d'amortissement du filtre réjecteur et le coefficient d'amortissement du filtre passe-haut étant supérieurs ou égaux à 0,3 et inférieurs ou égaux à $\sqrt{2}/2$ et par ailleurs, le coefficient d'amortissement du filtre passe-haut peut avantageusement être égal au coefficient d'amortissement du filtre réjecteur ;
- il comprend en outre un filtre passe-bande, le signal fourni par le filtre réjecteur étant appliqué en entrée du filtre passe-bande ;
- le filtre passe-haut est du quatrième ordre ;
- les filtres présentent des pics de résonance, les fréquences et l'amplitude des pics étant choisies pour que la variation du spectre entre le pic à la fréquence la plus faible et le pic à la fréquence la plus élevée soit inférieure ou égale à 15 dB, voire plus préférentiellement à 10 dB ;
- il est conçu pour fournir des impulsions UWB ;
  ladite fréquence donnée est supérieure ou égale à 900 MHz et plus préférentiellement à 3 GHz ;
- il comprend en outre un circuit de modulation tout ou rien modulant ledit signal sinusoïdal fourni par l'oscillateur avec un signal numérique, dans lequel le signal sinusoïdal modulé est appliqué à l'entrée du filtre réjecteur de bande ;
- les fronts du signal numérique sont synchronisés avec le passage à zéro du signal sinusoïdal fourni par l'oscillateur ;
- le circuit de modulation comprend un interrupteur interposé entre l'oscillateur et le filtre réjecteur de bande, l'interrupteur étant commandée par le signal numérique à émettre ;
- le circuit de modulation comprend un circuit mélangeur effectuant le produit entre le signal sinusoïdal et le signal numérique à émettre, le signal résultant étant appliquée en entrée du filtre réjecteur de bande.

Selon un autre aspect, l'invention propose aussi un émetteur radiofréquence, comprenant un générateur d'impulsions selon l'invention.

L'invention propose encore un émetteur radiofréquence comprenant une pluralité de générateurs d'impulsions selon l'invention, chacun des générateurs fournissant des impulsions dans une bande spectrale respective.

Enfin, l'invention propose d'utiliser un oscillateur fournissant un signal sinusoïdal à une fréquence donnée et un filtre réjecteur de bande dont la fréquence de réjection correspond à la fréquence du signal sinusoïdal fourni pour produire une impulsion UWB.

D'autres caractéristiques et avantages de l'invention apparaîtront à la lecture de la description qui suit d'un mode de réalisation préféré de l'invention, donnée à titre d'exemple et en référence au dessin annexé.

La figure 1 représente un schéma synoptique d'un générateur d'impulsions selon l'invention et la figure 2 un mode de réalisation du filtre réjecteur de bande de la figure 1.

Les figures 3a et 3b montrent les diagrammes de Bode d'un filtre réjecteur de bande de la figure 2.

Les figures 4a à 4c montrent les signaux temporels en différents points d'un générateur selon un mode de réalisation de l'invention, la figure 4d montrant les courbes spectres correspondantes.

La figure 5 montre un mode de réalisation d'un filtre passe-haut du deuxième ordre.

Les figures 6a et 6b illustrent l'influence du coefficient d'amortissement du filtre réjecteur de bande du deuxième ordre sur le spectre et la réponse temporelle à la sortie de celui-ci.

Les figures 7a à 7f illustrent un mode de réalisation de l'invention recourant à un filtre réjecteur de bande du deuxième ordre et un filtre passe-haut du quatrième ordre.

Les figures 7g à 7j illustrent un autre mode de réalisation de l'invention recourant à un filtre réjecteur de bande du deuxième ordre et un filtre passe-haut du quatrième ordre.

La figure 8 représente un schéma synoptique d'un émetteur radiofréquence UWB selon l'invention et la figure 9 représente les chronogrammes obtenus en différents points de l'émetteur.

La figure 10 représente une variante du schéma synoptique de la figure 8 et la figure 11 les chronogrammes correspondants.

Les figures 12 à 14 illustrent trois mises en oeuvre possibles du schéma synoptique de la figure 7.

La figure 15 illustre des chronogrammes relatifs aux durées des impulsions UWB générées par rapport à un signal numérique à émettre.

Le générateur d'impulsions selon l'invention est basé sur la génération d'un signal sinusoïdal exponentiellement amorti. La fréquence du signal et son amortissement sont choisis pour occuper au moins la largeur de bande spectrale requise. Pour cela, on peut avantageusement recourir à un oscillateur fournissant un signal sinusoïdal appliqué à l'entrée d'un filtre réjecteur de bande dont la fréquence de réjection correspond à la fréquence du signal sinusoïdal.

Le signal sinusoïdal exponentiellement amorti peut éventuellement faire l'objet d'un traitement tel qu'un filtrage passe-haut ou passe-bande pour adapter son spectre au gabarit spectral souhaité.

En définissant le filtre réjecteur de bande et le cas échéant les filtres subséquents de façon appropriée, l'invention permet de fournir des impulsions ultra-large bande souhaitées. En particulier, il est possible avec l'invention de générer des impulsions répondant aux masques du tableau n° 1.

Dans le cadre de la présente invention, une impulsion ne correspond pas nécessairement à un pic unique d'un signal dans le domaine temporel, mais peut correspondre à une suite d'alternances qui finissent par s'amortir. Par ailleurs, dans le cadre de la présente invention, l'on comprend par une impulsion ultra-large bande :

- soit une impulsion dont la largeur de bande fractionnée est supérieure à 0,1, de préférence à 0,2 et plus avantageusement à 0,25 ;
- soit des impulsions occupant une bande spectrale ayant une largeur d'au moins 100 MHz à -10 dB, voir plus préférentiellement d'au moins 500 MHz à -10 dB.

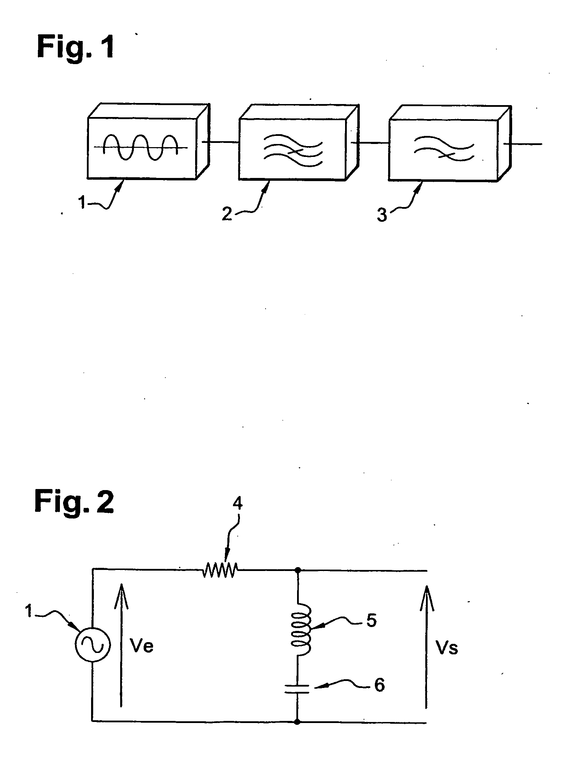

La figure 1 illustre le synoptique d'un circuit permettant de fournir un tel signal sinusoïdal exponentiellement amorti grâce à un oscillateur 1 et un filtre réjecteur de bande 2. L'oscillateur 1 est avantageusement un oscillateur local. L'oscillateur 1 fournit un signal sinusoïdal qui est appliqué en entrée du filtre réjecteur de bande 2. La fréquence de réjection du filtre 2 est choisie égale à la fréquence du signal sinusoïdal fourni par l'oscillateur 1. Par conséquent, le filtre 2 fournit en sortie un signal sinusoïdal exponentiellement amorti.

En effet, l'oscillateur 1 fournit un signal temporel s'exprimant sous la forme :

$$E(t) = A.\sin \omega_0 t$$

avec $\omega_0 = 2.\pi.f_0$ et $f_0$ la fréquence du signal sinusoïdal fourni par l'oscillateur 1 et sa transformée de Laplace est :

$$A.\omega_0/(\omega_0{}^2 + p^2)$$

Par ailleurs, l'équation temporelle d'une sinusoïde exponentiellement amortie peut s'exprimer sous la forme :

$$S(t) = K \frac{\omega_0}{\sqrt{1-m^2}} \cdot e^{-m \cdot \omega_0 \cdot t} \cdot Sin\left[\omega_0 \cdot \sqrt{1-m^2} \cdot t\right]$$

qui a pour transformée de Laplace :

$$\frac{K}{1 + \frac{2m}{\omega_0}p + \left(\frac{p}{\omega_0}\right)^2}$$

En omettant le facteur K/A, la transmittance permettant de passer de E(t) à S(t) s'exprime donc sous la forme :

$$T(p) = \frac{S(p)}{E(p)} = \frac{\frac{p^2}{\omega_0} + \omega_0}{1 + \frac{2 \cdot m}{\omega_0}p + \left(\frac{p}{\omega_0}\right)^2} = [\omega_0] \times \left[\frac{1 + \left(\frac{p}{\omega_0}\right)^2}{1 + \frac{2 \cdot m}{\omega_0}p + \left(\frac{p}{\omega_0}\right)^2}\right]$$

On reconnaît sous la dernière forme la transformée de Laplace d'un filtre réjecteur de bande du second ordre à un facteur de gain près.
Les paramètres K, m et $\omega_0$ permettent de contrôler les caractéristiques du signal sinusoïdal amorti comme suit :

- K : est le gain statique et permet d'ajuster le niveau d'amplitude ;
- m : est le coefficient d'amortissement et permet d'ajuster la vitesse d'extinction des oscillations ; et
- $\omega_0$ : est la pulsation propre et permet de caler le spectre dans la bande de fréquence souhaitée.

Afin que le générateur d'impulsions fournisse des impulsions avec la largeur de bande souhaitée, on fixe $f_0$ et m en tenant compte des considérations suivantes. La fréquence $f_0$ correspond à la borne de fréquence supérieure du spectre obtenu à la sortie du filtre réjecteur 2 au-delà de laquelle le spectre décroît. Le coefficient d'amortissement m permet de varier la largeur et la forme du spectre obtenu : nous reviendrons sur l'influence du coefficient d'amortissement m plus loin.
Dans un mode de réalisation, le filtre réjecteur 2 est du deuxième ordre. Il peut notamment être du type passif RLC comme illustré par la figure 2. En l'occurrence, le filtre réjecteur 2 est constitué par la résistance 4, l'inductance 5 et le condensateur 6. L'oscillateur 1 fournit une tension sinusoïdale Ve en entrée du filtre réjecteur qui fournit une tension sinusoïdale amortie Vs.
Classiquement, on a les relations suivantes :

$$\omega_0 = \frac{1}{\sqrt{L \cdot C}} \qquad m = \frac{R \cdot C}{2} \times \omega_0 = \frac{R \cdot C}{2 \cdot \sqrt{L \cdot C}} \qquad Q = \frac{1}{2m\sqrt{1-m^2}}$$

Ainsi, L et C sont choisis pour obtenir la fréquence $f_0$ souhaitée et R permet avantageusement de régler le coefficient d'amortissement m (et donc le facteur de qualité Q) à la valeur souhaitée sans influer sur la fréquence de réjection du filtre.
Le tableau n°2 illustre différentes valeurs des composants pour différentes fréquences $f_0$ en fixant dans tous les cas la capacité C du condensateur à 1 pF et le coefficient d'amortissement m à 0,39.

Tableau n° 2 :

| $f_0$ [GHz] | 3 | 4 | 5 | 6 | 7 | 8 | 9 | 10 |
|---|---|---|---|---|---|---|---|---|
| $\omega_0$ [GRad/s] | 18,85 | 25,13 | 31,42 | 37,7 | 43,98 | 50,27 | 56,55 | 62,83 |

(suite)

| f$_0$ [GHz] | 3 | 4 | 5 | 6 | 7 | 8 | 9 | 10 |
|---|---|---|---|---|---|---|---|---|
| R [Ω] | 42 | 31,5 | 25 | 21 | 18 | 16 | 14 | 12,6 |
| L [pH] | 2814 | 1583 | 1013 | 704 | 517 | 396 | 312,7 | 253 |
| C [pF] | 1 | 1 | 1 | 1 | 1 | 1 | 1 | 1 |
| m | 0,39 | 0,39 | 0,39 | 0,39 | 0,39 | 0,39 | 0,39 | 0,39 |
| Q | 1,37 | 1,37 | 1,37 | 1,37 | 1,37 | 1,37 | 1,37 | 1,37 |
| T$_0$/2 [ps] | 167 | 125 | 100 | 83,3 | 71,4 | 62,5 | 55,5 | 50 |

La dernière ligne du tableau donne la durée de la demi-période $T_0/2$ correspondant à la fréquence $f_0$. En l'occurrence, l'impulsion générée a une durée $T_0$ en négligeant le reste du signal qui est très fortement amorti.

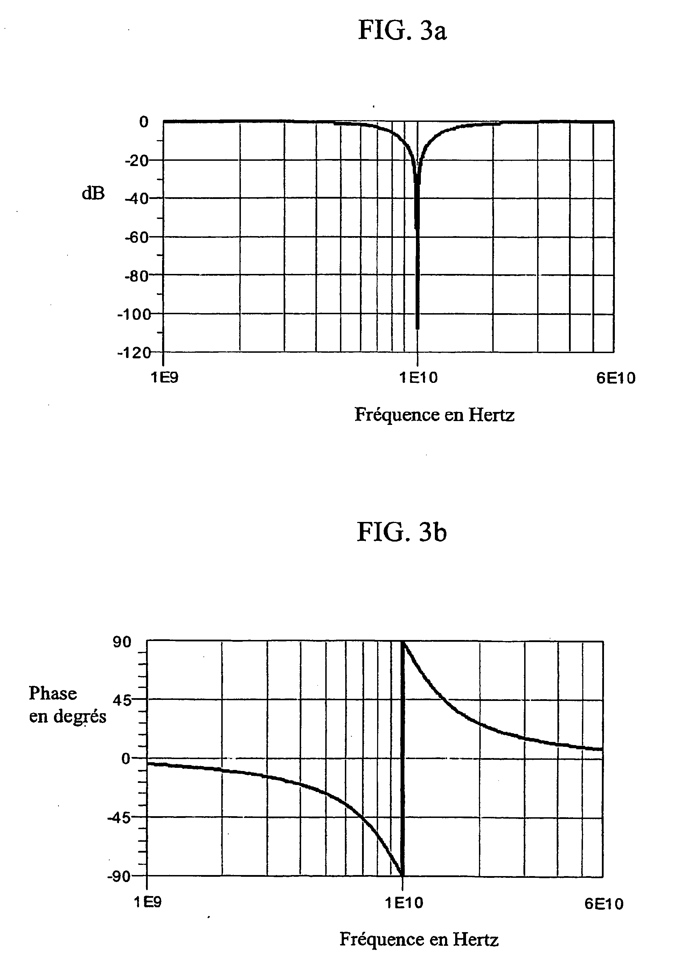

Les figures 3a et 3b illustrent les diagrammes de Bode respectivement pour l'amplitude et la phase du filtre réjecteur 2 ayant sa fréquence de réjection à 10 GHz.

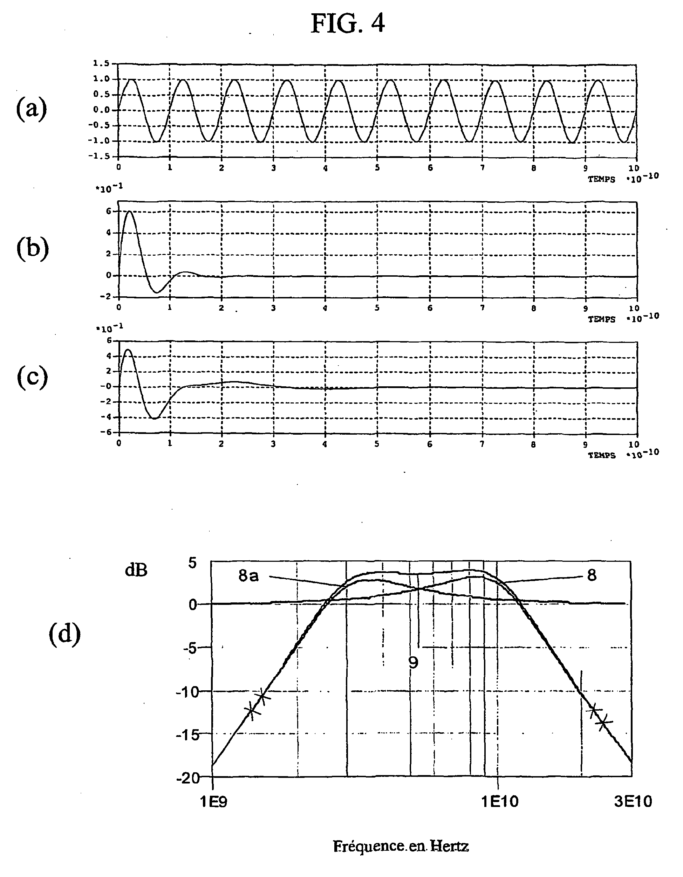

Les figures 4a et 4b illustrent les courbes dans le domaine temporel pour le cas de $f_0$ égale à 10 GHz. La figure 4a représente le signal sinusoïdal Ve fourni par l'oscillateur 1 tandis que la figure 4b représente le signal Vs obtenu à la sortie du filtre réjecteur 2. Pour ces deux figures, l'axe des abscisses représente le temps gradué en $10^{-10}$ secondes. Dans la figure 4a, l'axe des ordonnées est gradué en Volts tandis que dans la figure 4b il est gradué en dixième de Volts. Comme cela est visible, la tension de crête fournie par l'oscillateur 1 est de 1 Volt.

La courbe 8 de la figure 4d montre le spectre du signal à la sortie du filtre réjecteur 2. Comme cela est visible, ce spectre est de type ultra large bande puisqu'il s'étend de 0 à 10 GHz, après quoi il décline.

Dans le cas où il est souhaitable que le spectre ne s'étende pas en deçà d'une borne de fréquence non nulle, l'on pourra simplement corriger le signal obtenu en appliquant la sortie du filtre réjecteur 2 à l'entrée d'un filtre passe-haut 3 - cf. figure 1 - dont la fréquence de coupure est supérieure ou égale à la dite borne inférieure.

Dans le cas d'un filtre passe-haut 3 ayant sa fréquence de coupure fixée à 3 GHz, l'on obtient à sa sortie un signal qui, dans le domaine temporel, est représenté par la figure 4c, les axes étant graduée de la même manière que la figure 4b. La courbe caractéristique du filtre passe-haut 3 pris isolément est représentée sur la figure 4d par la référence 8a. Le spectre résultant du générateur à la sortie du filtre passe-haut 3 est représenté sur la figure 4d par la référence 8.

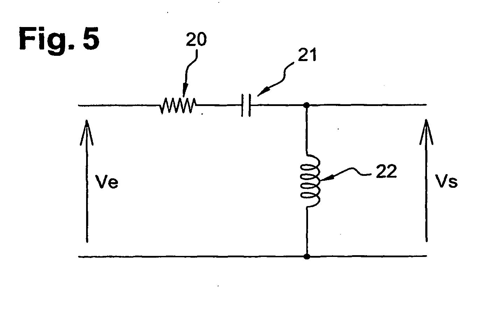

Le filtre passe-haut utilisé en l'occurrence est du deuxième ordre du type passif RLC qui est représenté à la figure 5.

La transformée de Laplace de la transmittance d'un tel filtre passe-haut s'écrit :

$$T(p) = \frac{S(p)}{E(p)} = \frac{\dfrac{p^2}{\omega_{0.ph}^2}}{1 + \dfrac{2 \cdot m_{ph}}{\omega_{0.ph}} \cdot p + \left(\dfrac{p}{\omega_{0.ph}}\right)^2}$$

dans laquelle :

$$\omega_{0.ph} = \frac{1}{\sqrt{L \cdot C}} \qquad m_{ph} = \frac{R \cdot C}{2} \times \omega_{0.ph} = \frac{R \cdot C}{2 \cdot \sqrt{L \cdot C}}$$

avec R, L, C les valeurs respectives de la résistance 20, du condensateur 21 et de l'inductance 22.

En l'occurrence, les courbes représentées correspondent au cas où la filtre passe-haut 3 est réalisé avec une résistance 20 de 42 ohms, une capacité 21 de 1 pF et une inductance 22 de 2,814 nH, ce qui procure un coefficient d'amortissement $m_{ph}$ de 0,39.

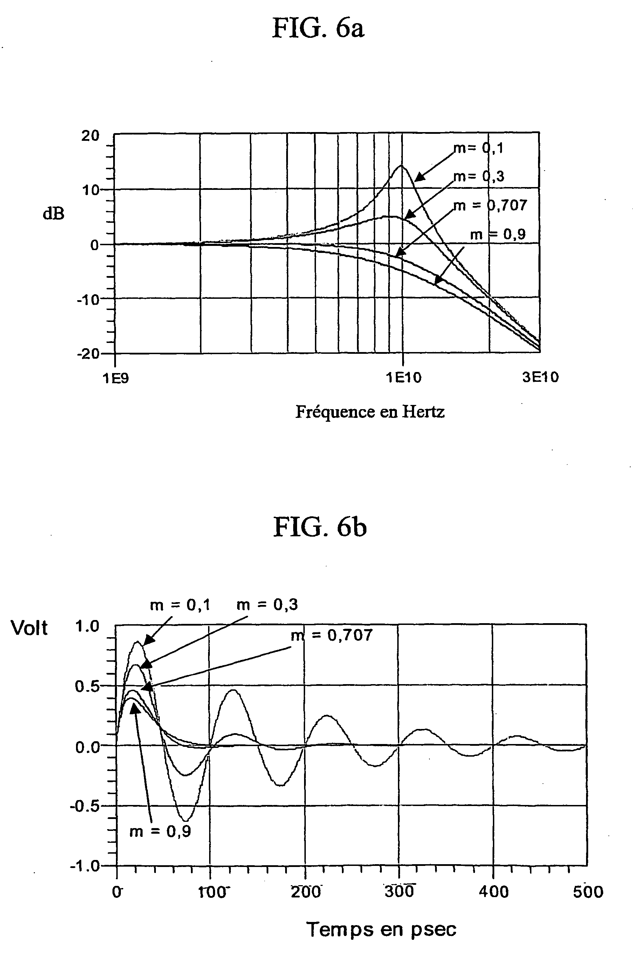

Comme déjà mentionné, le coefficient d'amortissement m du filtre réjecteur 2 permet de varier la largeur et la forme du spectre obtenu à sa sortie. Les figures 6a et 6b illustrent respectivement le spectre et la réponse temporelle obtenus à la sortie du filtre réjecteur 2 avec différentes valeurs de son coefficient d'amortissement m. Ainsi plus m est grand, plus l'amortissement de la sinusoïde est rapide. Lorsque m est inférieur à √2/2, c'est-à-dire environ 0,707, le spectre présente un pic de résonance proche de la fréquence de réjection qui est d'autant plus grand que m est petit. Lorsque m est supérieur à √2/2, le spectre ne présente plus de résonance, mais il décroît progressivement avec la fréquence, cette décroissance étant d'autant plus rapide que m est grand. Il est préférable d'avoir m inférieur ou égal à √2/2 car cela permet d'obtenir un spectre sensiblement plat tout en évitant une atténuation trop importante du niveau du signal de sortie du filtre réjecteur 2. Pareillement, il est préférable que m soit supérieur ou égal à 0,3 pour obtenir un spectre sensiblement plat car à des valeurs inférieures le spectre présente un pic de résonance très élevé par rapport aux fréquences voisines inférieures.

Dans le cas où on utilise un filtre passe-haut 3 du deuxième ordre, il est également préférable d'avoir le coefficient d'amortissement m du filtre réjecteur 2 dans ces limites pour les mêmes raisons, mais en outre il est avantageux de régler le coefficient d'amortissement $m_{ph}$ du filtre passe-haut 3 à une valeur sensiblement égale. Le filtre passe-haut et le filtre réjecteur peuvent donc chacun être réalisé avec des composants RLC ayant la même valeur. Dans ce cas, le spectre du filtre passe-haut 3 présente une résonance de même amplitude mais proche de la fréquence de coupure du filtre. 3. La mise en cascade du filtre réjecteur 2 et du filtre passe-haut 3 permet alors de symétriser le spectre et de l'aplanir dans la bande de fréquence souhaitée. Cette situation est illustrée par la figure 4d, le coefficient d'amortissement du filtre réjecteur 2 et du filtre passe-haut 3 étant tout deux égal à 0,39, le filtre passe-haut ayant une fréquence de coupure de 3 GHz. Comme déjà indiqué, la courbe 8 est le spectre obtenu à la sortie du filtre réjecteur 2 auquel est appliqué le signal sinusoïdal de l'oscillateur 1 à 10 GHz. La courbe 8a est la courbe de réponse spectrale du filtre passe-haut 3 pris isolément. La courbe 9 est le signal résultant à la sortie du filtre passe-haut 3 mis en cascade avec le filtre réjecteur 2 alimenté par l'oscillateur 1. Il reste préférable de maintenir le coefficient d'amortissement du filtre réjecteur 2 et celui du filtre passe-haut 3 supérieur ou égal à 0,3 car en deçà, le spectre résultant présente deux pics de résonances formant un puits entre eux au lieu d'être sensiblement plat dans la bande de fréquence souhaitée.

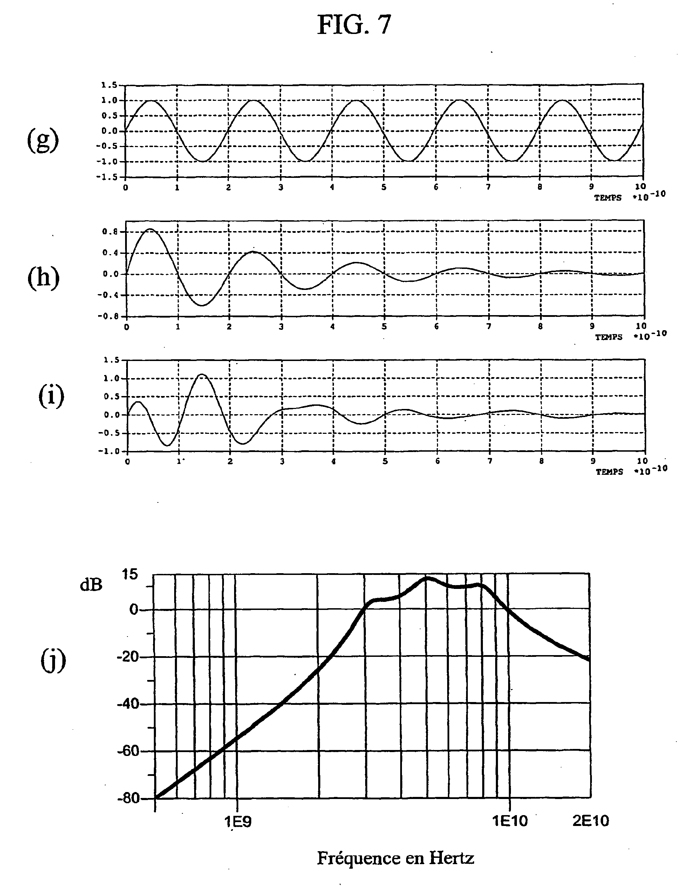

Concernant le filtre réjecteur 2, il est possible de recourir à un coefficient d'amortissement m inférieur à 0,3. Dans ce cas, il est préférable de recourir à un filtre passe-haut 3 permettant d'égaliser dans une certaine mesure le spectre de l'impulsion dans la bande de fréquence souhaitée. Ceci peut notamment être réalisé avec un filtre passe-haut 3 du quatrième ordre comme par exemple dans le mode de réalisation décrit plus loin en référence aux figures 7g à 7j. Mais même dans ce cas, il est préférable de maintenir le coefficient d'amortissement m à une valeur supérieure ou égale à 0,1 afin de permettre une égalisation suffisante du spectre dans la bande de fréquence considérée.

De façon générale, il est préférable que le ou les fréquences de résonance du filtre réjecteur 2 et le ou les fréquences de résonance du filtre passe-haut 3, voir passe-bande selon le cas, soient situées dans la bande de fréquences dans laquelle l'application va travailler. Dans ce cas, le ou les fréquences de résonance du filtre réjecteur 2 et le ou les fréquences de résonance du filtre passe-haut 3, voir passe-bande selon le cas, et l'amplitude des pics correspondants peuvent être choisies pour fournir une égalisation du spectre de l'impulsion dans la bande de fréquences allant du premier pic (celui de fréquence la plus faible) au dernier pic (celui de fréquence la plus élevée). On les choisit avantageusement pour que la variation du spectre à l'intérieur de cette bande soit inférieure ou égale à 15 dB, voire plus préférentiellement à 10 dB.

Dans le cas où il est souhaitable d'avoir une décroissance plus rapide du spectre des impulsions obtenues du côté des hautes fréquences, il peut être recouru à un filtre réjecteur 2 d'ordre supérieur à 2. Similairement du côté des fréquences basses, il peut être recouru à un filtre passe-haut 3 d'ordre supérieur à 2. Ces considérations sont aussi applicables au cas où on utilise un filtre passe-bande au lieu d'un filtre passe-haut 3.

Il est également possible de jouer sur la fréquence de l'oscillateur 1 et/ou la fréquence de coupure du filtre passe-haut 3 pour que le spectre obtenu soit à l'intérieur du gabarit spectral souhaité. Plus précisément, la fréquence de l'oscillateur 1 - qui est égale à la fréquence de coupure du filtre réjecteur 2 - peut être choisie inférieure à la borne supérieure du gabarit spectral à respecter pour faire tenir le spectre obtenu dans le gabarit du côté des fréquences hautes. Similairement, la fréquence de coupure du filtre passe-haut 3 peut être choisie supérieure à la borne inférieure du gabarit spectral à respecter pour faire tenir le spectre obtenu dans le gabarit du côté des fréquences basses.

En particulier, si l'on souhaite mettre en oeuvre un générateur d'impulsions pour des applications entrant dans les masques de la FCC pour les applications d'intérieur, les dispositifs portables et les applications d'imagerie haute-fréquence, il est préférable qu'au moins le filtre passe-haut 3 soit du quatrième ordre, voire aussi le filtre réjecteur 2.

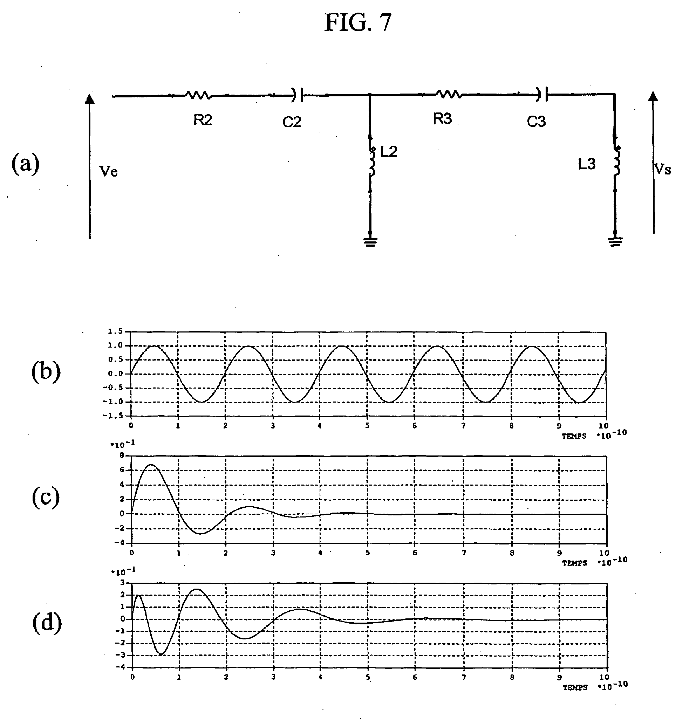

Les figures 7a à 7f illustrent un exemple de réalisation de l'invention fournissant des impulsions dont le spectre s'étend entre 3 et 10 GHz. L'oscillateur 1 fournit un signal sinusoïdal à 5 GHz. La fréquence de réjection du filtre réjecteur 2 est donc 5 GHz. Le filtre réjecteur 2 est un filtre RLC du deuxième ordre présentant un coefficient d'amortissement m égal à 0,318 et un facteur de qualité Q = 1,66. En référence à la figure 2, ce filtre réjecteur est obtenu avec la résistance 4 valant 18 ohms, l'inductance 5 valant 1 nH et la capacité 6 valant 1 pF. Le filtre passe-haut 3 est du quatrième ordre avec une fréquence de coupure à 5,6 GHz. Dans notre exemple, il est réalisé avec deux cellules RLC du deuxième ordre en cascade comme illustré par la figure 7a. La transformée de Laplace de la transmittance d'un tel filtre passe-haut s'écrit :

$$T_{PH\_4}(p) = \frac{\alpha \cdot p^4}{\alpha \cdot p^4 + \beta \cdot p^3 + \chi \cdot p^2 + \delta \cdot p + 1}$$

avec :

$\alpha = L_2 \cdot L_3 \cdot C_2 \cdot C_3$
$\beta = C_2 \cdot C_3 \cdot (L_2 \cdot (R_2 + R_3) + L_3 \cdot R_2)$
$\chi = C_2 \cdot (C_3 \cdot R_2 \cdot R_3 + L_2) + C_3 \cdot (L_2 + L_3)$
$\delta = R_2 \cdot C_2 + R_3 \cdot C_3$

En l'occurrence, $R_2 = R_3 = 18$ ohms, $L_2 = L_3 = 0,8$ nH et $C_2 = C_3 = 1$ pF.

Les figures 7b, 7c et 7d représentent le signal obtenu dans le domaine temporel respectivement à la sortie de l'oscillateur 1, du filtre réjecteur 2 et du filtre passe-haut 3 avec l'axe des abscisses gradué en $10^{-10}$ secondes et l'axe des ordonnées graduées en Volts pour la figure 7b et en dixième de Volts pour les figures 7c et 7d.

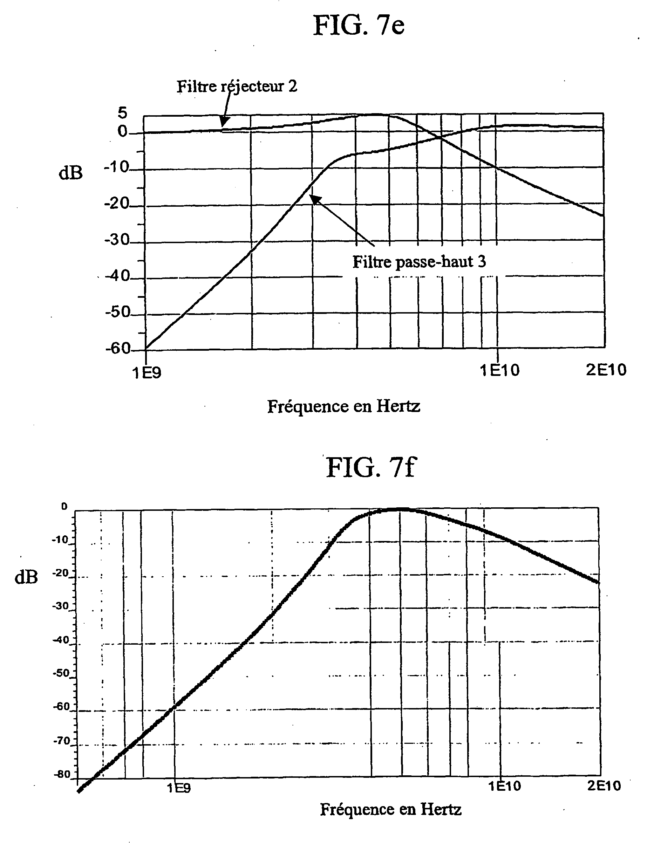

La figure 7e représente la courbe de réponse spectrale du filtre réjecteur 2 pris seul et celle du filtre passe-haut 3 pris seul. La figure 7f montre le spectre résultant correspondant à l'impulsion fournie à la sortie du filtre passe-haut 3 du générateur.

Les figures 7g à 7j illustrent un autre mode de réalisation dans lequel l'oscillateur 1 fournit aussi un signal sinusoïdal à 5 GHz. La fréquence de coupure du filtre réjecteur 2 est donc aussi 5 GHz. Mais le coefficient d'amortissement m du filtre réjecteur 2 est égal à 0,11. En référence à la figure 2, ce filtre réjecteur est obtenu avec la résistance 4 valant 7 ohms, l'inductance 5 valant 1 nH et la capacité 6 valant 1 pF. Le filtre passe-haut 3 est du quatrième ordre avec une fréquence de coupure à 5 GHz. Dans notre exemple, il est réalisé avec deux cellules RLC du deuxième ordre en cascade comme illustré par la figure 7a. En l'occurrence, $R_2 = 1$ ohm, R3 = 14 ohms, $L_2 = L_3 = 1$ nH, et $C_2 = C_3 = 1$ pF.

Les figures 7g, 7h et 7i représentent le signal obtenu dans le domaine temporel respectivement à la sortie de l'oscillateur 1, du filtre réjecteur 2 et du filtre passe-haut 3 avec l'axe des abscisses gradué en $10^{-10}$ secondes et l'axe des ordonnées graduées en Volts.

La figure 7j représente le spectre de l'impulsion fournie à la sortie du filtre passe-haut 3 du générateur. Comme cela est visible, le spectre est avantageusement à un niveau supérieure ou égale à 0 dB dans toute la bande allant de 3 à 10 GHz avec un maximum de +13dB à 5 GHz. Cela est obtenu en l'occurrence par le fait que le pic de résonance du filtre réjecteur 2 est placé entre les deux pics de résonance du filtre passe-haut 3. De plus, les filtres réjecteur 2 et passe-haut 3 sont intégralement réalisables en composants discrets dans ce mode de réalisation.

De façon générale, bien que non représenté dans les différentes figures, une adaptation d'impédance entre l'oscillateur 1 et le filtre réjecteur 2 ainsi qu'entre le filtre réjecteur 2 et le filtre passe-haut 3 est le cas échéant prévue de façon classique.

Il est aussi possible de réaliser des applications multibandes dans le domaine spectrale UWB autorisé par la FCC à l'aide de plusieurs générateurs d'impulsions selon l'invention. A titre d'exemple, les bandes considérées ont une largeur de 500 à 800 MHz. Pour chaque bande, on utilise un générateur d'impulsions spécifique. Les paramètres des différents éléments de chaque générateur d'impulsions qui ont été discutés précédemment, sont fixés en conséquence. Dans le cas de filtre réjecteur 2 et/ou filtre passe-haut 3 du deuxième ordre, il peut être avantageux de choisir un coefficient d'amortissement correspondant plus petit - inférieur à 0,3 - pour concentrer l'énergie du signal dans la bande considérée. En variante, on utilise pour chaque bande de fréquences, un couple respectif d'oscillateur 1 et de filtre réjecteur 2 qui est identique pour chaque bande et qui fournit un spectre couvrant l'ensemble des bandes de fréquences. On adjoint à chaque couple d'oscillateur/filtre réjecteur un filtre passe-bande calibré sur la bande de fréquence considérée à la place du filtre passe-haut 3.

Le filtre réjecteur 2 peut être non seulement de type passif RLC du deuxième ordre comme décrit, mais de tout autre type comme une cellule passive en double T, une succession d'un filtre passe-bas et d'un filtre passe-haut ou sous forme de filtre actif. Le recours à une structure RLC du deuxième ordre est toutefois avantageuse du fait de sa simplicité et son faible coût. Le filtre passe-haut 3 peut aussi être de tout type connu approprié autre que RLC du deuxième ordre ou du quatrième ordre, mais là encore une structure à base de RLC est avantageuse en raison de sa simplicité et de son faible coût.

Comme cela résulte du tableau n°2, le filtre réjecteur 2 peut être mis en oeuvre par des composants discrets notamment en technologie CMS au moins jusqu'à une fréquence de 5 GHz. C'est le cas aussi pour le filtre passe-haut 3 ou le filtre passe-bande selon le cas. Le filtre réjecteur 2, le filtre passe-haut 3 ou passe-bande peuvent aussi être réalisés sous forme de lignes de transmission ou micro-rubans (« microstrip » en anglais) particulièrement adaptés au cas des très hautes fréquences. C'est le cas notamment des filtres recourent à des capacités inférieures à 1 pF ou à des inductances inférieures à 1 nH.

Comme indiqué, la fréquence de réjection du filtre réjecteur 2 est égale à la fréquence de l'oscillateur 1. Si cette égalité n'est pas observée strictement, l'on obtient à la sortie du filtre réjecteur 2 et le cas échéant du filtre passe-haut 3, outre les impulsions souhaitées, un signal sinusoïdal permanent dont l'amplitude est d'autant plus grande que l'erreur est importante. En pratique, une telle erreur est acceptable dans la mesure où l'amplitude du signal sinusoïdal permanent résultant en sortie du filtre 2 est suffisamment basse pour ne pas compromettre le bon fonctionnement des applications UWB. La marge d'erreur acceptable dépend de la technologie du filtre réjecteur 2. Pour un filtre réjecteur 2 du type RLC du deuxième ordre, il est préférable que la fréquence de l'oscillateur 1 soit égale à la fréquence de réjection à +/-2% près. Mais le filtre réjecteur 2 peut être conçu pour ne pas présenter un simple pic de réjection comme c'est le cas pour un filtre RLC classique, cf. figure 3a, mais une plage de réjection avec la fréquence de l'oscillateur 1 comprise à l'intérieur de cette plage.

Dans le cas d'un filtre 2 réjecteur du type RLC, l'on tient également compte des résistances parasites que peuvent présenter l'inductance L et la capacité C en choisissant R suffisamment grand par rapport à ces résistances parasites pour éviter de générer un signal sinusoïdal permanent à la sortie du filtre 2 ou pour le maintenir à une amplitude suffisamment faible pour ne pas compromettre le bon fonctionnement de l'application UWB.

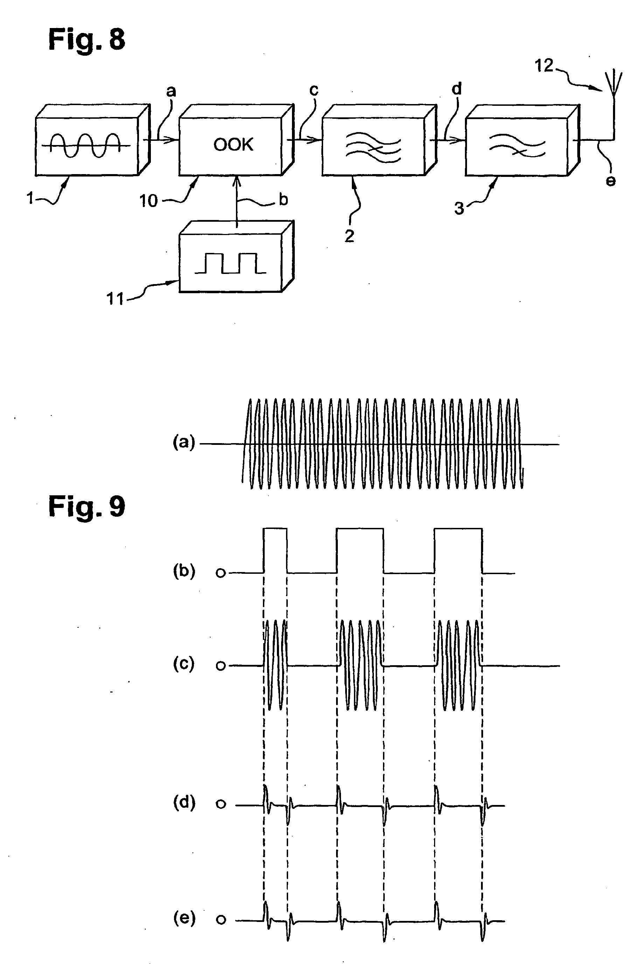

Dans les différentes applications UWB, les impulsions générées par le ou les générateurs d'impulsions sont déclenchées aux moments voulus par un circuit approprié, ces moments étant déterminés par un signal de commande. Nous allons illustrer un tel circuit pour une application de radiotransmission numérique UWB en référence à la figure 8 pour le générateur d'impulsions décrit en relation avec la figure 1. Dans ce cas, le signal de commande des impulsions correspond en fait au signal numérique à transmettre.

Comme nous l'avons vu précédemment, le générateur d'impulsions génère une impulsion lorsque le signal sinusoïdal de l'oscillateur 1 est appliqué à l'entrée du filtre réjecteur 2. Dès lors, pour générer une suite d'impulsions, il suffit d'appliquer le signal sinusoïdal à l'entrée du filtre réjecteur 2 à chaque fois que l'on souhaite générer une impulsion. Pour cela, une solution consiste à moduler en tout ou rien - modulation dite « OOK » en anglais - le signal sinusoïdal fourni par l'oscillateur 1 par le signal numérique à émettre 11 avant de l'injecter à l'entrée du filtre réjecteur 2, comme illustré par la figure 8. Le modulateur est référencé 10. Le train d'impulsions fourni à la sortie du filtre passe-haut 3 - ou à défaut, à la sortie du filtre réjecteur 2 - est appliqué à une antenne d'émission UWB 12 le cas échéant par l'intermédiaire d'un amplificateur large bande non représenté par commodité.

La figure 9 représente les chronogrammes obtenus en différents points du circuit :

- le chronogramme (a) est obtenu à la sortie de l'oscillateur 1 ;
- le chronogramme (b) est le signal numérique à émettre ;
- le chronogramme (c) est obtenu après modulation du signal sinusoïdal de l'oscillateur 1 par le signal numérique à émettre ;
- le chronogramme (d) est obtenu à la sortie du filtre réjecteur 2 ; et
- le chronogramme (e) est obtenu à la sortie du filtre passe-haut 3.

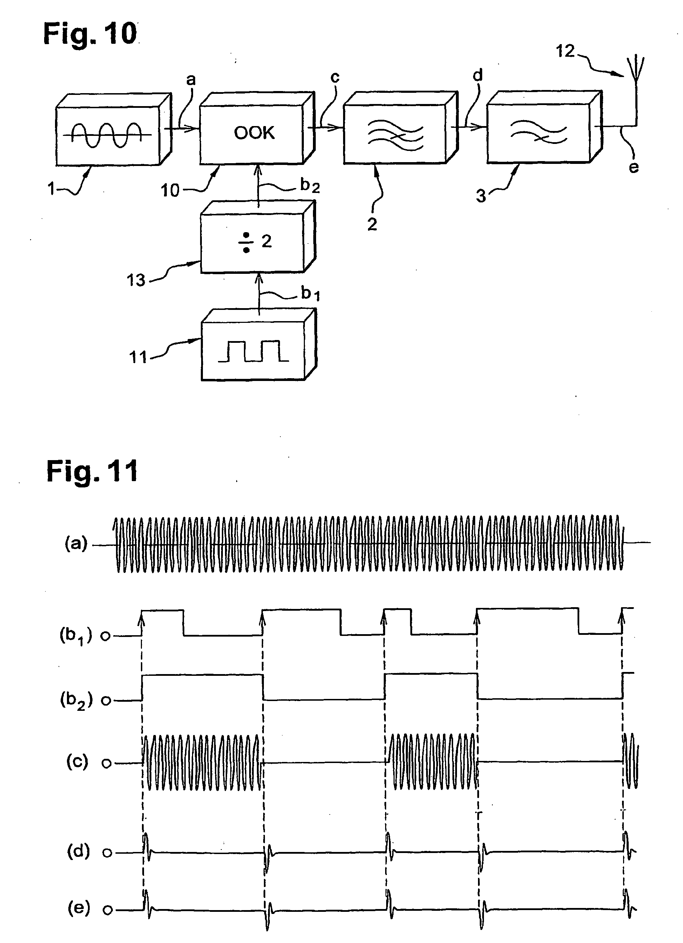

Comme cela est visible sur les chronogrammes, les impulsions apparaissent à chaque transition du signal numérique, aussi bien sur le front descendant que sur le front montant. S'il est souhaité émettre les impulsions que sur l'un des fronts et non les deux, il suffit de modifier le signal numérique à émettre en supprimant le front pour lequel l'on souhaite éviter le déclenchement d'une impulsion. Comme illustré par la figure 10, ceci peut être obtenu en appliquant le signal numérique à émettre à l'entrée d'un circuit diviseur de fréquence par deux ou d'une bascule D dont la sortie module le signal sinusoïdal fourni par l'oscillateur 1. Le circuit diviseur ou la bascule D est référencé 13. La figure 11 illustre les chronogrammes en différents points du circuit, les lettre utilisées définissant les mêmes points que pour les figures 8 et 9 sauf à préciser que $(b_1)$ est le signal numérique à émettre et que $(b_2)$ est le signal numérique obtenu après suppression des fronts descendants du signal $(b_1)$. Comme cela est visible, les impulsions sont déclenchées seulement sur les fronts montants du signal numérique à émettre $(b_1)$.

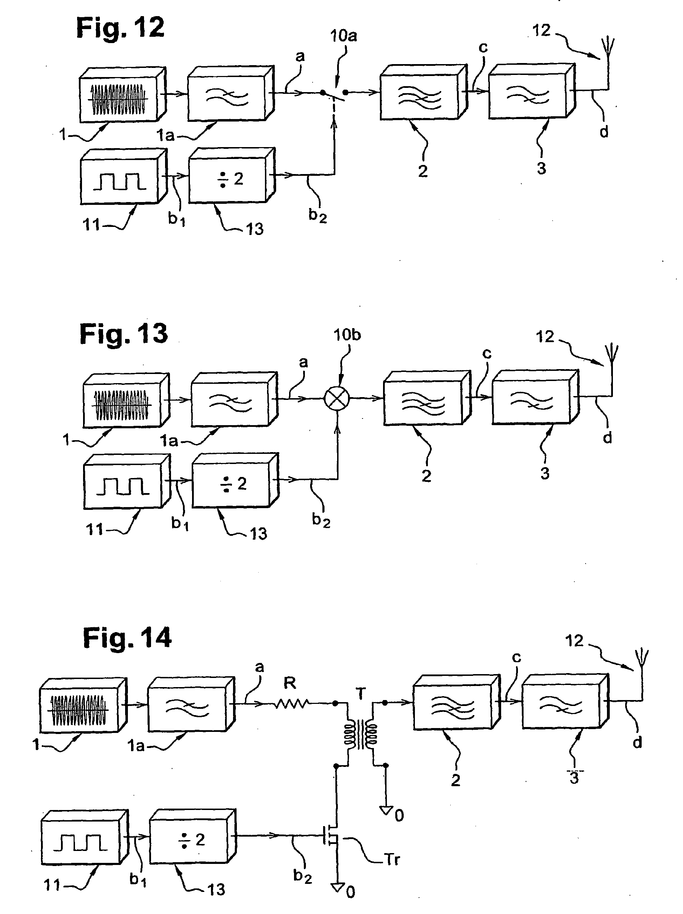

La figure 12 illustre la mise en oeuvre préférée de la modulation OOK du signal fourni par l'oscillateur 1 par le signal numérique à émettre après suppression éventuelle de l'un de ses fronts comme décrit précédemment. Le modulateur OOK 10 y est mis en oeuvre sous la forme d'un interrupteur ou commutateur 10a qui est commandé par le signal numérique à émettre $b_2$.

Ainsi, lorsque le signal numérique $b_2$ est à l'état haut, l'interrupteur 10a est fermé et lorsque le signal numérique $b_2$ est à l'état bas, l'interrupteur 10a est ouvert. Lorsque l'interrupteur 10a passe à l'état fermé, le signal sinusoïdal fourni par l'oscillateur 1 est appliqué en entrée du filtre réjecteur 2, ce qui provoque la génération d'une impulsion. Aucune autre impulsion est générée tant que l'interrupteur est maintenu fermé puisque la génération de l'impulsion correspond au régime transitoire résultant du filtre réjecteur 2, le filtre réjecteur en régime permanent ne fournissant aucun signal en sortie. Ensuite, lorsque l'interrupteur 10a passe à l'état ouvert, une nouvelle impulsion est générée.

L'interrupteur 10a peut être de tout type approprié tel qu'un transistor de type MOSFET, FET ou bipolaire ou une diode PIN. On sélectionne préférentiellement l'interrupteur 10a avec une vitesse élevée en commutation par rapport à la période du signal numérique à émettre $b_2$. Le fait que la commutation de l'interrupteur 10a n'est pas instantanée induit une modification de l'enveloppe du signal sinusoïdal de l'oscillateur 1 appliqué à l'entrée du filtre réjecteur 2. Cela provoque un rétrécissement du côté des fréquences basses du spectre de l'impulsion obtenue à la sortie du filtre réjecteur 2, ce rétrécissement étant dépendant de la pente de la vitesse de commutation de l'interrupteur 10a. Cet effet n'est pas gênant dans la mesure où les fréquences basses ne sont pas autorisées par la FCC. Par ailleurs, on tient compte des capacités parasites de l'interrupteur 10a dans la conception du circuit.

Optionnellement, un filtre passe-bas peut être branché à la sortie de l'oscillateur 1 et en entrée du modulateur 10 - en l'occurrence l'interrupteur 10a - pour éliminer les harmoniques de l'oscillateur 1 dans le but d'obtenir un signal sinusoïdal pur en sortie.

La figure 13 illustre une mise en oeuvre alternative de la modulation OOK par rapport à celle décrite en relation avec la figure 12. Le modulateur OOK 10 y est mis en oeuvre sous la forme d'un circuit mélangeur ou multiplieur 10b. Le signal sinusoïdal fourni par l'oscillateur 1 et le signal numérique à émettre $b_2$ sont appliqués en entrée du mélangeur 10b qui fournit en sortie le produit des deux signaux d'entrée.

La figure 14 illustre une autre mise en oeuvre alternative de la modulation OOK par rapport à celle décrite en relation avec la figure 12. Le modulateur OOK 10 y est mis en oeuvre à l'aide d'un transformateur T auquel est appliqué au primaire le signal sinusoïdal fourni par l'oscillateur 1 à travers une résistance R. Un commutateur, par exemple un transistor Tr de type MOS, est interposé dans le circuit primaire et est commandé par le signal numérique à émettre. Le circuit secondaire du transformateur T est connecté à l'entrée du filtre réjecteur 2. Le signal sinusoïdal de l'oscillateur 1c est donc appliqué au primaire du transformateur T que lorsque le signal numérique à émettre $b_2$ est à l'état haut et le secondaire du transformateur procure le signal modulé voulu.

La mise en oeuvre à base d'un commutateur ou interrupteur décrite en relation avec la figure 12 est préférée par rapport à celles des figures 13 et 14 étant donné sa simplicité, son faible coût et sa possibilité d'intégration dans une puce électronique.

Dans les applications de radiotransmission de données, le signal numérique à émettre résulte d'un codage numérique des données. En particulier, l'émetteur UWB décrit peut avantageusement mettre en oeuvre un codage de type PPM, c'est-à-dire une modulation par la position de l'impulsion (de l'anglais « Pulse Position Modulation ») pour transmettre les données numériques. En effet, l'émetteur selon l'invention présente une précision temporelle sur la latence à la génération des impulsions UWB par rapport aux fronts de déclenchement du signal numérique à émettre meilleure que celle des circuits de l'art antérieur basé sur l'effet avalanche d'un transistor ou sur une diode à tunnel.

De façon générale, il est préférable que deux fronts consécutifs du signal numérique à émettre soient séparés d'une durée supérieure à celle d'une impulsion générée par le générateur d'impulsion afin d'assurer que les impulsions générées présentent à chaque fois le spectre voulu. La durée d'une impulsion peut être fixée conventionnellement, par exemple en considérant qu'une impulsion prend fin après un nombre n de périodes de durée To - avec To la période du signal délivré par l'oscillateur 1 - après lesquelles l'amplitude des alternances suivantes du signal fourni par le générateur d'impulsions est inférieure à 1/50, voire 1/100 de l'amplitude maximale atteinte par le signal.

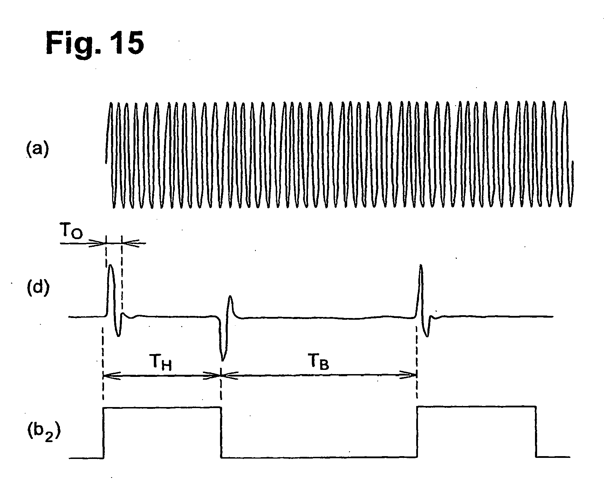

La figure 15 en fournit une illustration dans le cas du générateur d'impulsion fonctionnant dans les conditions de la colonne $f_0$ égale à 10 GHz du tableau 2. La durée de l'impulsion produite par le générateur d'impulsion à la sortie du filtre passe-haut 3 peut être considérée par exemple comme étant de $5.T_0$ étant donné que le reste du signal est très fortement amorti et ne contribue plus à fournir le spectre souhaité. Dès lors, la durée $T_H$ entre un front montant et le front descendant subséquent du signal numérique à émettre $b_2$ est de préférence plus grande que $5.T_0$. Similairement, la durée $T_B$ entre un front descendant et le front montant subséquent du signal numérique à émettre $b_2$ est de préférence plus grande que $5.T_0$.

Enfin, il est préférable de synchroniser la modulation OOK avec le passage au zéro du signal fourni par l'oscillateur 1 de façon à assurer que les impulsions générées aient toutes la même forme temporelle et spectrale. Par exemple, dans le cas de la figure 12, on synchronise la fermeture et l'ouverture de l'interrupteur 10a avec le passage à zéro de l'oscillateur 1. Cette synchronisation peut être réalisée de façon connue.

L'émetteur UWB selon l'invention peut être utilisé dans des applications monobandes. Dans le cas d'applications multibandes, il suffit d'utiliser un émetteur UWB spécifique à chaque bande.

Bien entendu, la présente invention n'est pas limitée aux exemples et au mode de réalisation décrits et représentés, mais elle est susceptible de nombreuses variantes accessibles à l'homme de l'art. En particulier, le générateur d'impulsions et l'émetteur selon l'invention peuvent être utilisés dans d'autres applications que la radiocommunication, par exemple dans les applications d'imagerie ou de radars. Par ailleurs, le signal sinusoïdal fourni par l'oscillateur 1 peut faire l'objet d'une modification de son enveloppe avant d'être appliqué à l'entrée du filtre réjecteur 2 par exemple pour optimiser le spectre obtenu en sortie du filtre 2. Enfin, les modes de réalisation décrits concernent le domaine des hyperfréquences (i.e. les fréquences supérieures à 900 MHz) et les masques d'émission spectrale de la FCC, mais l'invention est applicable à toute autre gamme d'ondes, qu'il s'agisse notamment d'ondes électromagnétiques ou acoustiques. Il convient de remarquer aussi que l'invention est capable d'être mise en oeuvre pour des fréquences d'oscillateur supérieures à 10 GHz.

**Revendications**

1. Générateur d'impulsions, comprenant :

   - un oscillateur (1) fournissant un signal sinusoïdal à une fréquence donnée ; et
   - un filtre réjecteur de bande (2) dont la fréquence de réjection correspond à la fréquence du signal sinusoïdal fourni par l'oscillateur ;

   dans lequel ledit signal sinusoïdal est appliqué à l'entrée du filtre réjecteur de bande.

2. Générateur d'impulsions selon la revendication 1, dans lequel ledit signal sinusoïdal fait l'objet d'une modification de son enveloppe avant d'être appliqué à l'entrée du filtre réjecteur de bande (2).

3. Générateur selon la revendication 1 ou 2, dans lequel le filtre réjecteur est d'un ordre supérieur ou égal à deux.

4. Générateur selon la revendication 1 ou 2, dans lequel le filtre réjecteur est du deuxième ordre présentant un coefficient d'amortissement supérieur ou égal à 0,1 et inférieur ou égal à $\sqrt{2}/2$.

5. Générateur selon l'une quelconque des revendications 1 à 4, comprenant en outre un filtre passe-haut (3), le signal fourni par le filtre réjecteur (2) étant appliqué en entrée du filtre passe-haut.

6. Générateur selon la revendication 5, dans lequel le filtre passe-haut (3) est du deuxième ordre.

7. Générateur selon la revendication 6, dans lequel le filtre réjecteur est du deuxième ordre, le coefficient d'amortissement du filtre réjecteur et le coefficient d'amortissement du filtre passe-haut étant supérieurs ou égaux à 0,3 et inférieurs ou égaux à $\sqrt{2}/2$.

8. Générateur selon la revendication 6 ou 7, dans lequel le filtre réjecteur (2) est du deuxième ordre, le coefficient d'amortissement ($m_{ph}$) du filtre passe-haut (3) étant égal au coefficient d'amortissement (m) du filtre réjecteur.

9. Générateur selon l'une quelconque des revendications 1 à 4, comprenant en outre un filtre passe-bande, le signal fourni par le filtre réjecteur (2) étant appliqué en entrée du filtre passe-bande.

10. Générateur selon la revendication 5, dans lequel le filtre passe-haut est du quatrième ordre.

11. Générateur selon l'une quelconque des revendications 1 à 10, dans lequel les filtres présentent des pics de résonance, les fréquences et l'amplitude des pics étant choisies pour que la variation du spectre entre le pic à la fréquence la plus faible et le pic à la fréquence la plus élevée soit inférieure ou égale à 15 dB, voire plus préférentiellement à 10 dB.

12. Générateur selon l'une quelconque des revendications 1 à 11, conçu pour fournir des impulsions UWB.

13. Générateur selon l'une quelconque des revendications 1 à 12, dans lequel ladite fréquence donnée est supérieure ou égale à 900 MHz et plus préférentiellement à 3 GHz.

14. Générateur selon l'une quelconque des revendications 1 à 13, comprenant en outre un circuit de modulation (10) tout ou rien modulant ledit signal sinusoïdal fourni par l'oscillateur (1) avec un signal numérique, dans lequel le signal sinusoïdal modulé est appliqué à l'entrée du filtre réjecteur de bande (2).

15. Générateur selon la revendication 14, dans lequel les fronts du signal numérique sont synchronisés avec le passage à zéro du signal sinusoïdal fourni par l'oscillateur.

16. Générateur selon la revendication 14 ou 15, dans lequel le circuit de modulation comprend un interrupteur (10a) interposé entre l'oscillateur (1) et le filtre réjecteur de bande (2), l'interrupteur étant commandée par le signal numérique à émettre.

17. Générateur selon la revendication 14 ou 15, dans lequel le circuit de modulation comprend un circuit mélangeur (10b) effectuant le produit entre le signal sinusoïdal et le signal numérique à émettre, le signal résultant étant appliquée en entrée du filtre réjecteur de bande (2).

18. Emetteur radiofréquence, comprenant un générateur d'impulsions selon l'une quelconque des revendications 1 à 17.

19. Emetteur radiofréquence comprenant une pluralité de générateurs d'impulsions selon l'une quelconque des revendications 1 à 17, chacun des générateurs fournissant des impulsions dans une bande spectrale respective.

20. Utilisation d'un oscillateur (1) fournissant un signal sinusoïdal à une fréquence donnée et d'un filtre réjecteur de bande (2) dont la fréquence de réjection correspond à la fréquence du signal sinusoïdal fourni pour produire une impulsion UWB, le signal sinusoïdal étant appliqué à l'entrée du filtre réjecteur de bande.

21. Utilisation selon la revendication 20 dans laquelle ledit signal sinusoïdal fait l'objet d'une modification de son enveloppe avant d'être appliqué à l'entrée du filtre réjecteur de bande (2).

**Claims**

1.  A pulse generator, comprising:

    - an oscillator (1) providing a sine-wave signal at a given frequency; and
    - a band rejection filter (2), the rejection frequency of which corresponds to the frequency of the sine-wave signal provided by the oscillator;

    wherein said sine-wave signal is applied to the input of the band rejection filter.

2.  The pulse generator according to claim 1, in which said sine-wave signal is subject to a modification of its envelope prior to being applied to the input of the band rejection filter (2).

3.  The generator according to claim 1 or 2, wherein the rejection filter is of an order greater than or equal to 2.

4.  The generator according to claim 1 or 2, wherein the rejection filter is of the second order having a damping coefficient larger than or equal to 0.1 and less than or equal to $\sqrt{2}/2$.

5.  The generator according to any of claims 1 to 4, further comprising a high-pass filter (3), the signal provided by the rejection filter (2) being applied at the input of the high-pass filter.

6.  The generator according to claim 5, wherein the high-pass filter (3) is of the second order.

7.  The generator according to claim 6, wherein the rejection filter is of the second order, the damping coefficient of the rejection filter and the damping coefficient of the high-pass filter being larger than or equal to 0.3 and less than or equal to $\sqrt{2}/2$ .

8.  The generator according to claim 6 or 7, wherein the rejection filter (2) is of the second order, the damping coefficient ($m_{ph}$) of the high-pass filter (3) being equal to the damping coefficient (m) of the rejection filter.

9.  The generator according to claim 1 to 4, further comprising a band-pass filter, the signal provided by the rejection filter (2) being applied at the input of the band-pass filter.

10. The generator according to claim 5, wherein the high-pass filter is of the fourth order.

11. The generator according to any of claims 1 to 10, wherein the filters have resonance peaks, the frequencies and the amplitude of the peaks being selected so that the variation of the spectrum between the peak at the lowest frequency and the peak at the highest frequency is less than or equal to 15 dB, or even more preferentially 10 dB.

12. The generator according to any of claims 1 to 11, designed for providing UWB pulses.

13. The generator according to any of claims 1 to 12, wherein said given frequency is larger than or equal to 900 MHz and more preferentially 3 GHz.

**14.** The generator according to any of claims 1 to 13, further comprising an on/off key modulation circuit (10) modulating said sine-wave signal provided by the oscillator (1) with a digital signal, wherein the modulated sine-wave signal is applied to the input of the band rejection filter (2).

**15.** The generator according to claim 14, wherein the edges of the digital signal are synchronized with the zero-crossing of the sine-wave signal provided by the oscillator.

**16.** The generator according to claim 14 or 15, wherein the modulation circuit comprises a switch (10a) interposed between the oscillator (1) and the band rejection filter (2), the switch being controlled by the digital signal to be transmitted.

**17.** The generator according to claim 14 or 15, wherein the modulation circuit comprises a mixer circuit (10b) forming the product between the sine-wave signal and the digital signal to be transmitted, the resulting signal being applied at the input of the band rejection filter (2).

**18.** A radiofrequency transmitter, comprising a pulse generator according to any of claims 1 to 17.

**19.** A radiofrequency transmitter comprising a plurality of pulse generators according to any of claims 1 to 17, each of the generators providing pulses in a respective spectrum band.

**20.** The use of an oscillator (1) providing a sine-wave signal at a given frequency and of a band rejection filter (2), the rejection frequency of which corresponds to the frequency of the sine-wave signal, provided for producing a UWB pulse, the sine-wave signal being applied to the input of the band rejection filter.

**21.** Use according to claim 20, in which said sine-wave signal is subject to a modification of its envelope prior to being applied to the input of the band rejection filter (2).


**Patentansprüche**

**1.** Impulsgenerator, umfassend:

- einen Oszillator (1), der ein Sinussignal mit einer bestimmten Frequenz bereitstellt; und
- ein Bandsperrfilter (2), dessen Sperrfrequenz der Frequenz des vom Oszillator bereitgestellten Sinussignals entspricht;

wobei das Sinussignal an den Eingang des Bandsperrfilters angelegt wird.

**2.** Impulsgenerator nach Anspruch 1, wobei das Sinussignal Gegenstand einer Modifikation seiner Hüllkurve ist, bevor es an den Eingang des Bandsperrfilters (2) angelegt wird.

**3.** Generator nach Anspruch 1 oder 2, wobei das Sperrfilter höherer Ordnung oder gleich zwei ist.

**4.** Generator nach Anspruch 1 oder 2, wobei das Sperrfilter zweiter Ordnung ist und einen Dämpfungskoeffizienten von gleich oder über 0,1 und von gleich oder unter $\sqrt{2}/2$ aufweist.

**5.** Generator nach einem der Ansprüche 1 bis 4, ferner umfassend ein Hochpassfilter (3), wobei das vom Sperrfilter (2) bereitgestellte Signal am Eingang des Hochpassfilters angelegt wird.

**6.** Generator nach Anspruch 5, wobei das Hochpassfilter (3) zweiter Ordnung ist.

**7.** Generator nach Anspruch 6, wobei das Sperrfilter zweiter Ordnung ist und der Dämpfungskoeffizient des Sperrfilters und der Dämpfungskoeffizient des Hochpassfilters gleich oder mehr als 0,3 und gleich oder weniger als $\sqrt{2}/2$ betragen.

**8.** Generator nach Anspruch 6 oder 7, wobei das Sperrfilter (2) zweiter Ordnung ist und der Dämpfungskoeffizient ($m_{ph}$) des Hochpassfilters (3) dem Dämpfungskoeffizienten (m) des Sperrfilters entspricht.

9. Generator nach einem der Ansprüche 1 bis 4, ferner umfassend ein Bandpassfilter, wobei das vom Sperrfilter (2) bereitgestellte Signal am Eingang des Bandpassfilters angelegt wird.

10. Generator nach Anspruch 5, wobei das Hochpassfilter vierter Ordnung ist.

11. Generator nach einem der Ansprüche 1 bis 10, wobei die Filter Resonanzspitzen aufweisen, wobei die Frequenzen und die Amplituden der Spitzen so gewählt sind, dass die Änderung des Spektrums zwischen der Spitze mit der niedrigsten Frequenz und der Spitze mit der höchsten Frequenz gleich oder weniger als 15 dB, noch bevorzugter 10 dB, beträgt.

12. Generator nach einem der Ansprüche 1 bis 11, der dazu vorgesehen ist, UWB-Impulse bereitzustellen.

13. Generator nach einem der Ansprüche 1 bis 12, wobei die bestimmte Frequenz gleich oder über 900 MHz, noch bevorzugter 3 GHz, ist.

14. Generator nach einem der Ansprüche 1 bis 13, ferner umfassend eine Ein-Aus-Modulationsschaltung (10), die das vom Oszillator (1) bereitgestellte Sinussignal mit einem digitalen Signal moduliert, wobei das modulierte Sinussignal an den Eingang des Bandsperrfilters (2) angelegt wird.

15. Generator nach Anspruch 14, wobei die Fronten des digitalen Signals mit dem Nulldurchgang des vom Oszillator bereitgestellten Sinussignals synchronisiert sind.

16. Generator nach Anspruch 14 oder 15, wobei die Modulationsschaltung einen Schalter (10a) umfasst, der zwischen dem Oszillator (1) und dem Bandsperrfilter (2) angeordnet ist, wobei der Schalter vom zu sendenden digitalen Signal gesteuert ist.

17. Generator nach Anspruch 14 oder 15, wobei die Modulationsschaltung eine Mischerschaltung (10b) umfasst, die das Produkt aus dem Sinussignal und dem zu sendenden digitalen Signal erhält, wobei das erhaltene Signal am Eingang des Bandsperrfilters (2) angelegt wird.

18. Radiofrequenzsender, umfassend einen Impulsgenerator nach einem der Ansprüche 1 bis 17.

19. Radiofrequenzsender, umfassend mehrere Impulsgeneratoren nach einem der Ansprüche 1 bis 17, wobei jeder der Generatoren Impulse in einem entsprechenden Spektralband bereitstellt.

20. Verwendung eines Oszillators (1), der ein Sinussignal mit einer bestimmten Frequenz bereitstellt, und eines Bandsperrfilters (2), dessen Sperrfrequenz der Frequenz des bereitgestellten Sinussignals entspricht, um einen UWB-Impuls zu erzeugen, wobei das Sinussignal an den Eingang des Bandsperrfilters angelegt wird.

21. Verwendung nach Anspruch 20, wobei das Sinussignal Gegenstand einer Modifikation seiner Hüllkurve ist, bevor es an den Eingang des Bandsperrfilters (2) angelegt wird.

# Fig. 1

# Fig. 2

# FIG. 3a

Fréquence en Hertz

# FIG. 3b

Fréquence en Hertz

# FIG. 4

(a)

(b)

(c)

(d)

Fréquence en Hertz

# Fig. 5

## FIG. 6a

## FIG. 6b

# FIG. 7

(a)

(b)

(c)

(d)

# FIG. 7e

Filtre réjecteur 2

Filtre passe-haut 3

dB

5
0
-10
-20
-30
-40
-50
-60

1E9  1E10  2E10

Fréquence en Hertz

# FIG. 7f

dB

0
-10
-20
-30
-40
-50
-60
-70
-80

1E9  1E10  2E10

Fréquence en Hertz

# FIG. 7

(g)

(h)

(i)

(j)

Fréquence en Hertz

**Fig. 8**

**Fig. 9**

# Fig. 10

# Fig. 11

**Fig. 12**

**Fig. 13**

**Fig. 14**

# Fig. 15

(a)

(d)

$T_O$

$T_H$

$T_B$

(b$_2$)

**EP 1 810 415 B1**

## RÉFÉRENCES CITÉES DANS LA DESCRIPTION

**Documents brevets cités dans la description**

- US 5687169 A
- US 5677927 A
- US 5586145 A